# EUROPEAN PATENT SPECIFICATION

(11) **EP 4 037 185 B1**
(45) Date of publication and mention of the grant of the patent: **25.11.2026**
(21) Application number: 22152056.2
(22) Date of filing: 18.01.2022
(51) Int. Cl.: H03K 3/356

(54) **LEVEL SHIFTER**
PEGELSCHIEBER
DISPOSITIF DE DÉCALAGE DE NIVEAU

(30) Priority: 28.01.2021 US 202117161083
(43) Date of publication of application: 03.08.2022
(73) Proprietor: NXP B.V., 5656 AG Eindhoven (NL)
(72) Inventor: Goyal, Saurabh, 5656AG Eindhoven (NL); Tripathi, Divya, 5656Ag Eindhoven (NL); Wadhwa, Sanjay Kumar, 5656AG Eindhoven (NL)
(74) Representative: Schwarzweller, Thomas

(56) References cited:
- EP-A1- 2 892 154
- CN-U- 202 600 025
- US-A1- 2009 039 942
- US-A1- 2014 292 398

## Description

### BACKGROUND

The present disclosure relates generally to electronic circuits, and, more particularly, to a level shifter.

A system-on-chip (SoC) includes multiple components that operate under various voltage domains, *i.e.,* voltages that are in a peculiar range (such as, '0-1.8' volts). A level shifter is used as an interface between the components to shift voltage levels of input voltages associated with one voltage domain to voltage levels of output voltages associated with another voltage domain.

A conventional level shifter includes pull-up and pull-down circuits and a voltage protection circuit. The voltage protection circuit protects gate-to-source and drain-to-source voltages of transistors of the pull-up and pull-down circuits from reaching high voltages that may damage the transistors. Thus, the output voltages generated by the conventional level shifter are unable to reach minimum and maximum voltage levels of the other voltage domain. Further, the output voltages vary due to variations in process, voltage, and temperature (PVT) associated with the conventional level shifter. To reduce the effects of PVT variations on the output voltages, large-sized transistors are implemented in the voltage protection circuit. Inclusion of such large-sized transistors results in an increase in a size of the conventional level shifter and a degradation in a speed of operation of the conventional level shifter. Therefore, there exists a need for a level shifter that solves the aforementioned problems of the conventional level shifter.

US 2009/039942 A1 describes a level shifter. EP 2892154 A1 describes a level shifter circuit.

### SUMMARY

According to the invention, a level shifter is disclosed according to claim 1.

Further embodiments are described as set out in the dependent claims.

The output voltages are generated by the output generator such that the output voltages are able to reach minimum and maximum voltage levels of the other voltage domain, and the output voltages do not vary due to variations in process, voltage, and temperature (PVT) associated with the level shifter. Additionally, a need to utilize large-sized transistors in the protection circuit is eliminated. Thus, a size of the level shifter is reduced and a speed of operation of the level shifter is increased as compared to conventional level shifters that utilize large-sized transistors in a protection circuit of the conventional level shifters.

### BRIEF DESCRIPTION OF THE DRAWINGS

The following detailed description of the preferred embodiments of the present disclosure will be better understood when read in conjunction with the appended drawings. The present disclosure is illustrated by way of example, and not limited by the accompanying figures, in which like references indicate similar elements.
FIG. 1 is a schematic block diagram of a system-on-chip (SoC) in accordance with an embodiment of the present disclosure;
FIG. 2 is a schematic block diagram of a first level shifter of the SoC of FIG. 1 in accordance with an embodiment of the present disclosure;
FIG. 3 is a schematic block diagram of the SoC of FIG. 1 in accordance with another embodiment of the present disclosure; and
FIG. 4 is a schematic block diagram of a second level shifter of the SoC of FIG. 3 in accordance with another embodiment of the present disclosure.

### DETAILED DESCRIPTION

The detailed description of the appended drawings is intended as a description of the currently preferred embodiments of the present disclosure, and is not intended to represent the only form in which the present disclosure may be practiced. It is to be understood that the same or equivalent functions may be accomplished by different embodiments that are intended to be encompassed within the scope of the present disclosure.

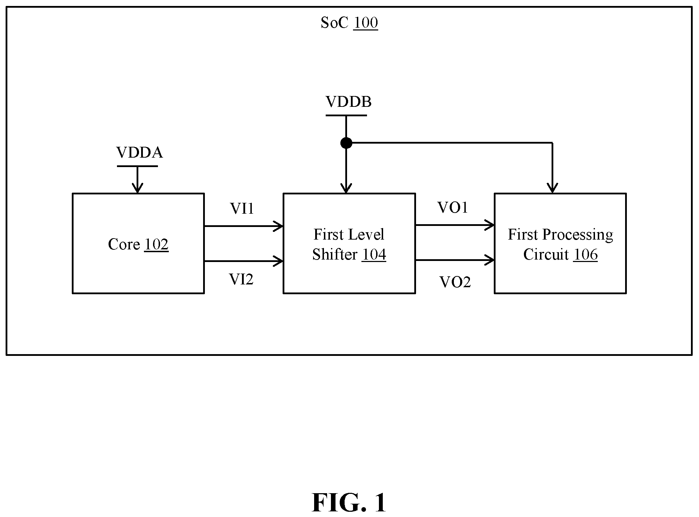

FIG. 1 is a schematic block diagram of a system-on-chip (SoC) 100 in accordance with an embodiment of the present disclosure. The SoC 100 may be utilized in applications that require different components of the SoC 100 to operate in different voltage domains. The SoC 100 includes a core 102, a first level shifter 104, and a first processing circuit 106.

The core 102 is a processing element of the SoC 100, and configured to receive a first supply voltage VDDA and generate first and second input voltages VI1 and VI2. In one embodiment, a first supply generator (not shown) is coupled with the core 102, and configured to generate and provide the first supply voltage VDDA to the core 102. The first supply generator may be included on the SoC 100. The core 102 is further configured to operate at the first supply voltage VDDA. The first and second input voltages VI1 and VI2 are associated with a first voltage domain. In one example, the first voltage domain corresponds to voltages in the range of '0 - 0.75' volts. Examples of the core 102 include, but are not limited to, a microprocessor core and a microcontroller core.

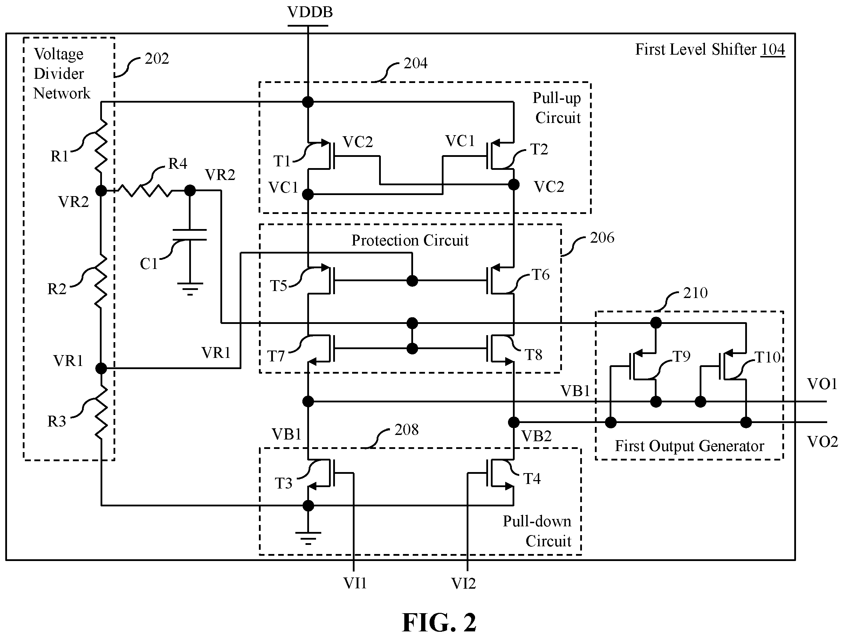

The first level shifter 104 is coupled with the core 102, and configured to receive a second supply voltage VDDB and the first and second input voltages VI1 and VI2, and shift voltage levels of the first and second input voltages VI1 and VI2 to generate first and second output voltages VO1 and VO2. In one embodiment, a second supply generator (not shown) is coupled with the first level shifter 104, and configured to generate and provide the second supply voltage VDDB to the first level shifter 104. The second supply generator may be included on the SoC 100. The first level shifter 104 is further configured to operate at the second supply voltage VDDB. In one example, the second supply voltage VDDB is '1.8' volts. The first and second output voltages VO1 and VO2 are associated with a second voltage domain. In one example, the second voltage domain corresponds to voltages in the range of '0 - 1.65' volts. The first level shifter 104 has been explained in detail in FIG. 2.

The first processing circuit 106 is coupled with the first level shifter 104, and configured to receive the first and second output voltages VO1 and VO2. The first processing circuit 106 is further coupled with the second supply generator, and further configured to receive the second supply voltage VDDB. In one example, the first processing circuit 106 includes a switching transistor (not shown) such that a gate terminal of the switching transistor is configured to receive one of the first and second output voltages VO1 and VO2 for controlling a switching operation of the switching transistor.

FIG. 2 is a schematic block diagram of the first level shifter 104 in accordance with an embodiment of the present disclosure. The first level shifter 104 includes a voltage divider network 202 that includes first through third resistors R1-R3 coupled in series, a fourth resistor R4, a first capacitor C1, a pull-up circuit 204, a protection circuit 206, a pull-down circuit 208, and a first output generator 210.

The voltage divider network 202 is coupled with the second supply generator, and configured to receive the second supply voltage VDDB and generate first and second reference voltages VR1 and VR2. The first resistor R1 is configured to receive the second supply voltage VDDB whereas the third resistor R3 is coupled with a ground terminal. The second resistor R2 is coupled between the first and third resistors R1 and R3. The first and second reference voltages VR1 and VR2 are generated based on a voltage drop across each of the first through third resistors R1-R3. The first reference voltage VR1 is generated between the second and third resistors R2 and R3, and the second reference voltage VR2 is generated between the first and second resistors R1 and R2. The voltage divider network 202 is further coupled with the protection circuit 206 and the first output generator 210, and further configured to provide the first and second reference voltages VR1 and VR2 to the protection circuit 206, and the second reference voltage VR2 to the first output generator 210.

The fourth resistor R4 is coupled with the voltage divider network 202, and configured to receive the second reference voltage VR2. The first capacitor C1 is coupled with the fourth resistor R4 and the ground terminal, and configured to charge to the second reference voltage VR2. The fourth resistor R4 and the first capacitor C1 are utilized to prevent back coupling of the first and second output voltages VO1 and VO2 due to transitions in the first and second output voltages VO1 and VO2.

The pull-up circuit 204 is configured to receive the second supply voltage VDDB and generate first and second control voltages VC1 and VC2. The pull-up circuit 204 includes first and second transistors T1 and T2. The first transistor T1 has a source terminal that is coupled with the second supply generator, and configured to receive the second supply voltage VDDB. The first transistor T1 further has a gate terminal that is configured to receive the second control voltage VC2, and a drain terminal that is configured to generate the first control voltage VC1. The first control voltage VC1 is thus generated based on the second supply voltage VDDB and the second control voltage VC2. The second transistor T2 has a gate terminal that is coupled with the drain terminal of the first transistor T1, and configured to receive the first control voltage VC1. The second transistor T2 further has a source terminal that is coupled with the second supply generator, and a drain terminal that is coupled with the gate terminal of the first transistor T1. The source terminal of the second transistor T2 is configured to receive the second supply voltage VDDB, and the drain terminal of the second transistor T2 is configured to generate and provide the second control voltage VC2 to the gate terminal of the first transistor T1. The second control voltage VC2 is thus generated based on the second supply voltage VDDB and the first control voltage VC1. In one example, the first and second transistors T1 and T2 are p-channel metal oxide semiconductor (PMOS) transistors.

The pull-down circuit 208 is coupled with the core 102, and configured to receive the first and second input voltages VI1 and VI2, and generate first and second bias voltages VB1 and VB2. The pull-down circuit 208 includes third and fourth transistors T3 and T4. The third transistor T3 has a gate terminal that is coupled with the core 102, and a source terminal coupled with a ground terminal. The gate terminal of the third transistor T3 is configured to receive the first input voltage VI1. The third transistor T3 further has a drain terminal that is configured to generate the first bias voltage VB1. The fourth transistor T4 has a gate terminal that is coupled with the core 102, and a source terminal that is coupled with the ground terminal. The gate terminal of the fourth transistor T4 is configured to receive the second input voltage VI2. The fourth transistor T4 further has a drain terminal that is configured to generate the second bias voltage VB2. In one example, the third and fourth transistors T3 and T4 are n-channel metal oxide semiconductor (NMOS) transistors.

The protection circuit 206 is coupled with the voltage divider network 202, the fourth resistor R4, and the first capacitor C1, and configured to receive the first and second reference voltages VR1 and VR2. The protection circuit 206 is further coupled between the pull-down circuit 208 and the pull-up circuit 204, and further configured to control the generation of the first and second bias voltages VB1 and VB2 and the first and second control voltages VC1 and VC2. The protection circuit 206 includes fifth through eighth transistors T5-T8. The fifth transistor T5 has a gate terminal that is coupled with the second and third resistors R2 and R3, and configured to receive the first reference voltage VR1. The fifth transistor T5 further has a source terminal that is coupled with the pull-up circuit 204 *(i.e.,* the drain terminal of the first transistor T1), and configured to control the generation of the first control voltage VC1. Based on the first reference voltage VR1 received at the gate terminal of the fifth transistor T5, the first control voltage VC1 flows from the source terminal of the fifth transistor T5 to a drain terminal of the fifth transistor T5.

The sixth transistor T6 has a gate terminal that is coupled with the second and third resistors R2 and R3, and configured to receive the first reference voltage VR1. The sixth transistor T6 further has a source terminal that is coupled with the pull-up circuit 204 *(i.e.,* the drain terminal of the second transistor T2), and configured to control the generation of the second control voltage VC2. Based on the first reference voltage VR1 received at the gate terminal of the sixth transistor T6, the second control voltage VC2 flows from the source terminal of the sixth transistor T6 to a drain terminal of the sixth transistor T6. In one example, when the first reference voltage VR1 is '0.35' volts and the second control voltage VC2 is '1.8' volts, the fifth transistor T5 controls the generation of the first control voltage VC1 such that the first control voltage VC1 is '0.35 + Vt' volts, where 'Vt' is a threshold voltage associated with the fifth transistor T5. Further, the second transistor T2 receives the first control voltage VC1 at the gate terminal thereof and thus a gate-to-source voltage (not shown) of the second transistor T2 is '1.45 - Vt' volts. Additionally, the first transistor T1 receives the second supply voltage VDDB, *i.e.,* '1.8' volts, at the source terminal thereof and thus a drain-to-source voltage (not shown) of the first transistor T1 is '1.45 - Vt' volts. Thus, the fifth transistor T5 is further configured to protect the drain-to-source voltage and the gate-to-source voltage of the first and second transistors T1 and T2, respectively, from reaching a high voltage, *i.e.,* '1.8' volts, that may damage the first and second transistors T1 and T2. Similarly, the sixth transistor T6 is further configured to protect a gate-to-source voltage and a drain-to-source voltage of the first and second transistors T1 and T2, respectively, from reaching the high voltage of 1.8 volts. In one example, the fifth and sixth transistors T5 and T6 are PMOS transistors.

The seventh transistor T7 has a gate terminal that is coupled with the fourth resistor R4 and the first capacitor C1, and configured to receive the second reference voltage VR2. The seventh transistor T7 further has a source terminal that is coupled with the pull-down circuit 208 *(i.e.,* the drain terminal of the third transistor T3), and a drain terminal that is coupled with the drain terminal of the fifth transistor T5. The source terminal of the seventh transistor T7 is configured to control the generation of the first bias voltage VB1. Based on the second reference voltage VR2 received at the gate terminal of the seventh transistor T7, the first bias voltage VB1 flows from the source terminal of the seventh transistor T7 to the drain terminal of the seventh transistor T7. The eighth transistor T8 has a gate terminal that is coupled with the fourth resistor R4 and the first capacitor C1, and configured to receive the second reference voltage VR2. The eighth transistor T8 further has a source terminal that is coupled with the pull-down circuit 208 *(i.e.,* the drain terminal of the fourth transistor T4), and a drain terminal coupled with the drain terminal of the sixth transistor T6. The source terminal of the eighth transistor T8 is configured to control the generation of the second bias voltage VB2. Based on the second reference voltage VR2 received at the gate terminal of the eighth transistor T8, the second bias voltage VB2 flows from the source terminal of the eighth transistor T8 to the drain terminal of the eighth transistor T8. The seventh and eighth transistors T7 and T8 are further configured to protect gate-to-source voltages and drain-to-source voltages of the third and fourth transistors T3 and T4 from reaching high voltages that may damage the third and fourth transistors T3 and T4. In one example, the seventh and eighth transistors T7 and T8 are NMOS transistors.

The first output generator 210 is coupled with the fourth resistor R4, the first capacitor C1, the pull-down circuit 208, and the protection circuit 206, and configured to receive the second reference voltage VR2 and the first and second bias voltages VB1 and VB2, and generate the first and second output voltages VO1 and VO2. The first output generator 210 includes ninth and tenth transistors T9 and T10. The ninth transistor T9 has a gate terminal that is coupled with the pull-down circuit 208 *(i.e.,* the drain terminal of the fourth transistor T4) and the protection circuit 206 *(i.e.,* the source terminal of the eighth transistor T8), and configured to receive the second bias voltage VB2. The ninth transistor T9 further has a source terminal that is coupled with the fourth resistor R4 and the first capacitor C1, and configured to receive the second reference voltage VR2. The ninth transistor T9 further has a drain terminal that is configured to generate the first output voltage VO1.

The tenth transistor T10 has a gate terminal that is coupled with the drain terminal of the ninth transistor T9, the pull-down circuit 208 *(i.e.,* the drain terminal of the third transistor T3), and the protection circuit 206 *(i.e.,* the source terminal of the seventh transistor T7), and configured to receive the first bias voltage VB1. The tenth transistor T10 further has a source terminal that is coupled with the fourth resistor R4 and the first capacitor C1, and configured to receive the second reference voltage VR2. The tenth transistor T10 further has a drain terminal that is coupled with the gate terminal of the ninth transistor T9, and configured to generate the second output voltage VO2. In one example, when the first input voltage VI1 is '0.75' volts and the second input voltage VI2 is '0' volts, the first bias voltage VB1 is '0' volts and the second bias voltage VB2 is '1.65 - Vt' volts and thus the ninth transistor T9 is in a non-conducting state and the tenth transistor T10 is in a conducting state. As a result, the tenth transistor T10 outputs the second reference voltage VR2 *(i.e.,* '1.65' volts) as the second output voltage VO2, and the ninth transistor T9 outputs the first bias voltage VB1 *(i.e.,* '0' volts) as the first output voltage VO1 such that the first and second output voltages VO1 and VO2 reach minimum and maximum voltage levels *(i.e.,* '0' volts and '1.65' volts, respectively) of the second voltage domain. In one example, the ninth and tenth transistors T9 and T10 are PMOS transistors.

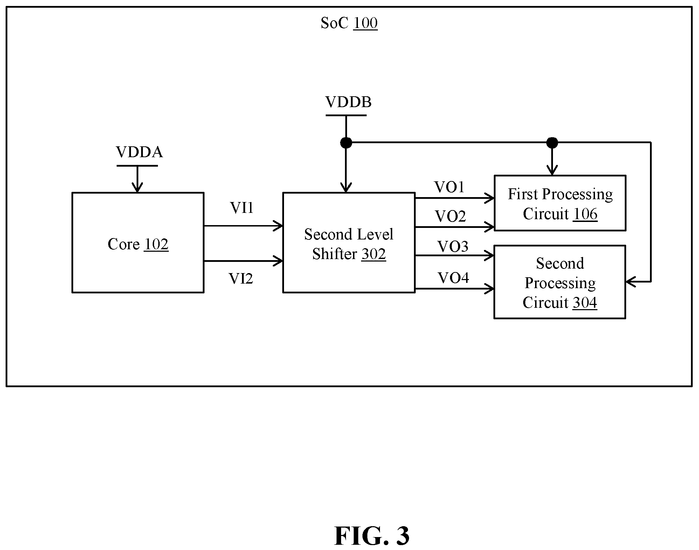

FIG. 3 is a schematic block diagram of the SoC 100 in accordance with another embodiment of the present disclosure. The SoC 100 includes the core 102, a second level shifter 302, the first processing circuit 106, and a second processing circuit 304. The core 102 functions in a similar manner as described in FIG. 1.

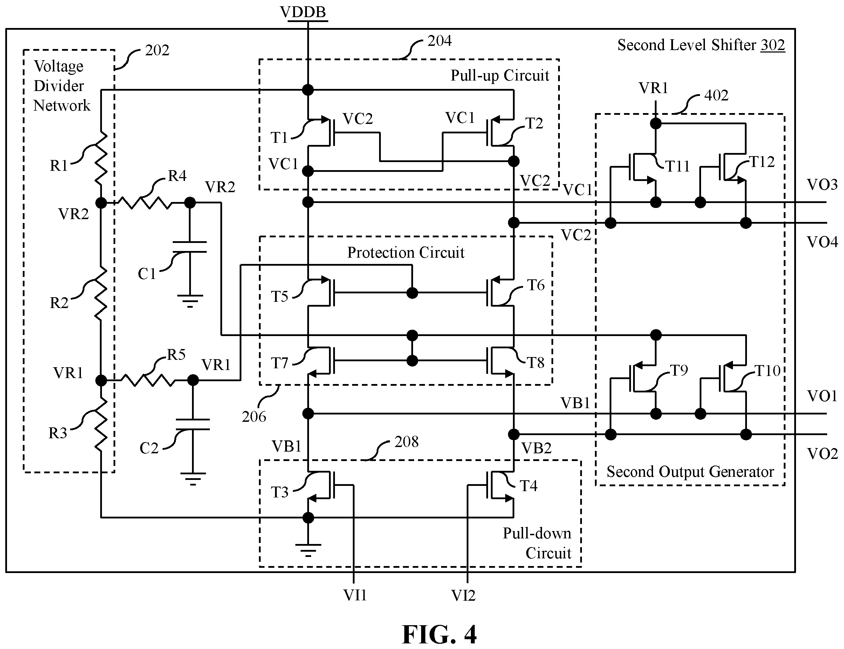

The second level shifter 302 is coupled with the core 102, and configured to receive the second supply voltage VDDB such that the second level shifter 302 is configured to operate at the second supply voltage VDDB. The second level shifter 302 is further configured to receive the first and second input voltages VI1 and VI2, and shift voltage levels of the first and second input voltages VI1 and VI2 to generate a plurality of output voltages, *i.e.,* the first and second output voltages VO1 and VO2 and third and fourth output voltages VO3 and VO4. In one example, the second supply voltage VDDB is '1.8' volts. The first and second output voltages VO1 and VO2 are associated with the second voltage domain, and the third and fourth output voltages VO3 and VO4 are associated with a third voltage domain. In one example, the second voltage domain corresponds to voltages in the range of '0 - 1.65' volts and the third voltage domain corresponds to voltages in the range of '0.35 - 1.8' volts. The second level shifter 302 has been explained in detail in FIG. 4.

The first processing circuit 106 functions in a similar manner as described in FIG. 1. The second processing circuit 304 is coupled with the second level shifter 302, and configured to receive the third and fourth output voltages VO3 and VO4. The second processing circuit 304 is further coupled with the second supply generator, and further configured to receive the second supply voltage VDDB. In one embodiment, the second processing circuit 304 may be structurally similar to the first processing circuit 106. In one example, the first and second processing circuits 106 and 304 include transistors (not shown) such that the transistors are controlled based on the first through fourth output voltages VO1-VO4 for executing various operations associated with the SoC 100.

FIG. 4 is a schematic block diagram of the second level shifter 302 in accordance with another embodiment of the present disclosure. The second level shifter 302 includes the voltage divider network 202 that includes the first through third resistors R1-R3 coupled in series, the fourth resistor R4, the first capacitor C1, a fifth resistor R5, a second capacitor C2, the pull-up circuit 204, the protection circuit 206, the pull-down circuit 208, and a second output generator 402.

The voltage divider network 202 is coupled with the second supply generator, and configured to receive the second supply voltage VDDB and generate the first and second reference voltages VR1 and VR2. The voltage divider network 202 is further coupled with the protection circuit 206 and the second output generator 402, and further configured to provide the first and second reference voltages VR1 and VR2 to the protection circuit 206 and the second output generator 402.

The first through third resistors R1-R3, the fourth resistor R4, and the first capacitor C1 function in a similar manner as described in FIG. 2. The fifth resistor R5 is coupled with the voltage divider network 202, and configured to receive the second reference voltage VR2. The second capacitor C2 is coupled with the fifth resistor R5 and the ground terminal, and configured to charge to the first reference voltage VR1. The fifth resistor R5 and the second capacitor C2 are utilized to prevent back coupling of the third and fourth output voltages VO3 and VO4 due to transitions in the third and fourth output voltages VO3 and VO4. The pull-up circuit 204, the pull-down circuit 208, and the protection circuit 206 function in a similar manner as described in FIG. 2.

The second output generator 402 is coupled with the pull-up circuit 204, the pull-down circuit 208, and the protection circuit 206, and configured to receive the first and second reference voltages VR1 and VR2, the first and second bias voltages VB1 and VB2, and the first and second control voltages VC1 and VC2, and generate the first through fourth output voltages VO1-VO4. The second output generator 402 includes the ninth and tenth transistors T9 and T10 and eleventh and twelfth transistors T11 and T12. The ninth and tenth transistors T9 and T10 function in a similar manner as described in FIG. 2.

The eleventh transistor T11 has a gate terminal that is coupled with the pull-up circuit 204 *(i.e.,* the drain terminal of the second transistor T2) and the protection circuit 206 *(i.e.,* the source terminal of the sixth transistor T6), and configured to receive the second control voltage VC2. The eleventh transistor T11 further has a drain terminal that is coupled with the fifth resistor R5 and the second capacitor C2, and configured to receive the first reference voltage VR1, and a source terminal that is configured to output the third output voltage VO3. Based on the second control voltage VC2 received at the gate terminal of the eleventh transistor T11, the first reference voltage VR1 flows from the drain terminal of the eleventh transistor T11 to the source terminal of the eleventh transistor T11.

The twelfth transistor T12 has a gate terminal that is coupled with the source terminal of the eleventh transistor T11, the pull-up circuit 204 *(i.e.,* the drain terminal of the first transistor T1), and the protection circuit 206 *(i.e.,* the source terminal of the fifth transistor T5), and configured to receive the first control voltage VC1. The twelfth transistor T12 further has a drain terminal that is coupled with the fifth resistor R5 and the second capacitor C2, and configured to receive the first reference voltage VR1. Further, the twelfth transistor T12 has a source terminal that is coupled with the gate terminal of the eleventh transistor T11, and configured to output the fourth output voltage VO4. Based on the first control voltage VC1 received at the gate terminal of the twelfth transistor T12, the first reference voltage VR1 flows from the drain terminal of the twelfth transistor T12 to the source terminal of the twelfth transistor T12. In one example, when the first input voltage VI1 is '0.75' volts and the second input voltage VI2 is '0' volts, the first control voltage VC1 is '0.35 + Vt' volts and the second control voltage VC2 is '1.8' volts and thus the eleventh transistor T11 is in a conducting state and the twelfth transistor T12 is in a non-conducting state. As a result, the eleventh transistor T11 outputs the first reference voltage VR1 *(i.e.,* '0.35' volts) as the third output voltage VO3, and the twelfth transistor T12 outputs the second control voltage VC2 *(i.e.,* '1.8' volts) as the fourth output voltage VO4 such that the third and fourth output voltages VO3 and VO4 reach minimum and maximum voltage levels *(i.e.,* '0.35' volts and '1.8' volts, respectively) of the third voltage domain. In one example, the eleventh and twelfth transistors T11 and T12 are NMOS transistors. It will be apparent to a person skilled in the art that a third level shifter (not shown) may be obtained by including a third output generator (not shown) that includes the eleventh and twelfth transistors T11 and T12 in place of the second output generator 402, in the second level shifter 302. The third output generator is thus configured to receive the first reference voltage VR1 and the first and second control voltages VC1 and VC2, and generate the third and fourth output voltages VO3 and VO4. The working of the third level shifter is similar to the second level shifter 302 and will be understood by a person skilled in the art.

As the first and second output voltages VO1 and VO2 are generated by the first output generator 210 (as explained in FIG. 2) and the first through fourth output voltages VO1-VO4 are generated by the second output generator 402 (as explained in FIG. 4), the first and second output voltages VO1 and VO2 are able to reach the minimum and maximum voltage levels associated with the second voltage domain whereas the first through fourth output voltages VO1-VO4 are able to reach the minimum and maximum voltage levels associated with one of the second and third voltage domains. Further, the first through fourth output voltages VO1-VO4 are based on the second and first bias voltages VB2 and VB1 and the second and first control voltages VC2 and VC1 received at the gate terminals of the ninth through twelfth transistors T9-T12, respectively, and the first and second reference voltages VR1 and VR2. Thus, the first through fourth output voltages VO1-VO4 are not directly based on an internal voltage drop associated with the ninth through twelfth transistors T9-T12, respectively, and remain unaffected due to variations in process, voltage, and temperature (PVT) associated with the first and second level shifters 104 and 302. Hence, a need to utilize large-sized transistors in the protection circuit 206 is eliminated and a size of the first and second level shifters 104 and 302 is reduced as compared to conventional level shifters that utilize large-sized transistors in a protection circuit of the conventional level shifters to compensate for PVT variations. Due to the reduced size, the first and second level shifters 104 and 302 operate at a higher speed as compared to the conventional level shifters.

A level shifter includes a pull-down circuit, a pull-up circuit, a protection circuit, and an output generator. The pull-down circuit is configured to receive input voltages, and generate bias voltages. The input voltages are associated with a voltage domain. The pull-up circuit is configured to receive a supply voltage and generate control voltages. The protection circuit is configured to receive reference voltages, and control the generation of the bias voltages and the control voltages. The output generator is configured to receive at least one of the reference voltages, and at least one of the bias voltages and the control voltages, and generate output voltages that are able to reach minimum and maximum voltage levels of another voltage domain. Further, the output voltages remain unaffected by variations in process, voltage, and temperature.

Although the disclosure is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to disclosures containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A level shifter (104), comprising:
a pull-down circuit (208) comprising:
a first pull-down circuit transistor (T3) that has (i) a gate terminal configured to receive a first input voltage (VI1), (ii) a source terminal coupled with a ground terminal, and (iii) a drain terminal configured to generate a first bias voltage (VB1); and
a second pull-down circuit transistor (T4) that has (i) a gate terminal configured to receive a second input voltage (VI2), (ii) a source terminal coupled with the ground terminal, and (iii) a drain terminal configured to generate a second bias voltage (VB2);
a pull-up circuit (204) comprising:
a first pull-up circuit transistor (T1) that has (i) a gate terminal configured to receive a second control voltage (VC2), (ii) a source terminal configured to receive a supply voltage (VDDB), and (iii) a drain terminal configured to generate a first control voltage (VC1); and a second pull-up circuit transistor (T2) that has (i) a gate terminal coupled with the drain terminal of the first pull-up circuit transistor (T1), and configured to receive the first control voltage (VC1), (ii) a source terminal configured to receive the supply voltage (VDDB), and (T1) (iii) a drain terminal coupled with the gate terminal of the first pull-up circuit transistor and configured to generate and provide the second control voltage (VC2) to the gate terminal of the first pull-up circuit transistor (T1);
a protection circuit (206) comprising:
a first protection circuit transistor (T5) that has (i) a gate terminal configured to receive a first reference voltage (VR1), and (ii) a source terminal coupled with the pull-up circuit (204), and configured to control the generation of the first control voltage (VC1);
a second protection circuit transistor (T6) that has (i) a gate terminal configured to receive the first reference voltage (VR1), and (ii) a source terminal coupled with the pull-up circuit (204), and configured to control the generation of the second control voltage (VC2);
a third protection circuit transistor (T7) that has (i) a gate terminal configured to receive the second reference voltage (VR2), (ii) a source terminal coupled with the pull-down circuit (208), and configured to control the generation of the first bias voltage (VB1), and (iii) a drain terminal coupled with a drain terminal of the first protection circuit transistor (T5); and
a fourth protection circuit transistor (T8) that has (i) a gate terminal configured to receive the second reference voltage (VR2), (ii) a source terminal coupled with the pull-down circuit (208), and configured to control the generation of the second bias voltage (VB2), and (iii) a drain terminal coupled with a drain terminal of the second protection circuit transistor (T6); and
an output generator (210) comprising:
a first output generator transistor (T9) that has (i) a gate terminal coupled with the pull-down circuit (208) and the protection circuit (206), and configured to receive the second bias voltage (VB2), (ii) a source terminal configured to receive the second reference voltage (VR2), and (iii) a drain terminal configured to generate a first output voltage (VO1); and
a second output generator transistor (T10) that has (i) a gate terminal coupled with the drain terminal of the first output generator transistor (T9), the pull-down circuit (208), and the protection circuit (206), and is configured to receive the first bias voltage (VB1), (ii) a source terminal configured to receive the second reference voltage (VR2), and (iii) a drain terminal coupled with the gate terminal of the first output generator transistor (T9), and configured to generate a second output voltage (VO2); wherein
the level shifter further comprises:
a voltage divider network that is coupled with the protection circuit (206) and the output generator (210), and configured to receive the supply voltage (VDDB), generate the first and second reference voltages (VR1, VR2), and provide (i) the first and second reference voltages to the protection circuit (206), and (ii) the second reference voltage (VR2) to the output generator (210); **characterized by**
a resistor (R4) that is coupled with the voltage divider network (202), and configured to receive the second reference voltage (VR2); and
a capacitor (C1) that is coupled with the resistor (R4) and a ground terminal, and configured to charge to the second reference voltage (VR2).

2. The level shifter (104) of claim 1, wherein the voltage divider network (202) comprises a first, second and third resistor (R1, R2, R3) coupled in series, wherein the first resistor (R1) is configured to receive the supply voltage and the third resistor (R3) is coupled with a ground terminal, and wherein the first and second reference voltages (VR1, VR2) are generated based on a voltage drop across each of the first (R1) through third resistors (R3).

3. The level shifter (302) of any preceding claim, wherein the output generator (402) is further coupled with the pull-up circuit (204) and further configured to receive the first reference voltage (VR1) and the first and second control voltages (VC1, VC2), and to further generate third and fourth output voltages (VO3, VO4), wherein the third and fourth output voltages (VO3, VO4) are associated with a third voltage domain.

4. The level shifter of claim 3, wherein the output generator further comprises:
a third output generator transistor (T11) that has (i) a gate terminal coupled with the pull-up circuit (204) and the protection circuit (206) , and configured to receive the second control voltage (VC2) , (ii) a drain terminal configured to receive the first reference voltage (VR1) , and (iii) a source terminal configured to output the third output voltage (VO3) ; and
a fourth output generator transistor (T12) that has (i) a gate terminal coupled with the source terminal of the third output generator transistor (T11), the pull-up circuit (204), and the protection circuit (206), and configured to receive the first control voltage (VC1), (ii) a drain terminal configured to receive the first reference voltage (VR1), and (iii) a source terminal coupled with the gate terminal of the third output generator transistor (T11), and configured to output the fourth output voltage (VO4).

5. The level shifter (302) of claim 3 or 4, wherein the voltage divider network (202) is further configured to provide the first reference voltage (VR1) to the output generator (402).

6. The level shifter(302) of claim 5, further comprising:
a further resistor (R5) that is coupled with the voltage divider network (202), and configured to receive the first reference voltage (VR1) ; and
a further capacitor (C2) that is coupled with the further resistor (R5) and the ground terminal, and configured to charge to the first reference voltage (VR1).

7. A system-on-chip, SoC, comprising the level shifter of any preceding claim.

## Patentansprüche

1. Pegelschieber (104), umfassend:
eine Pull-Down-Schaltung (208), umfassend:
einen ersten Pull-Down-Schaltungstransistor (T3), der Folgendes aufweist: (i) einen Gate-Anschluss, der dazu ausgelegt ist, eine erste Eingangsspannung (VI1) zu empfangen, (ii) einen Source-Anschluss, der mit einem Masseanschluss gekoppelt ist, und (iii) einen Drain-Anschluss, der dazu ausgelegt ist, eine erste Vorspannung (VB1) zu erzeugen; und
einen zweiten Pull-Down-Schaltungstransistor (T4), der Folgendes aufweist: (i) einen Gate-Anschluss, der dazu ausgelegt ist, eine zweite Eingangsspannung (VI2) zu empfangen, (ii) einen Source-Anschluss, der mit dem Masseanschluss gekoppelt ist, und (iii) einen Drain-Anschluss, der dazu ausgelegt ist, eine zweite Vorspannung (VB2) zu erzeugen;
eine Pull-Up-Schaltung (204), umfassend:
einen ersten Pull-Up-Schaltungstransistor (T1), der Folgendes aufweist: (i) einen Gate-Anschluss, der dazu ausgelegt ist, eine zweite Steuerspannung (VC2) zu empfangen, (ii) einen Source-Anschluss, der dazu ausgelegt ist, eine Versorgungsspannung (VDDB) zu empfangen, und (iii) einen Drain-Anschluss, der dazu ausgelegt ist, eine erste Steuerspannung (VC1) zu erzeugen, sowie einen zweiten Pull-Up-Schaltungstransistor (T2), der Folgendes aufweist: (i) einen Gate-Anschluss, der mit dem Drain-Anschluss des ersten Pull-Up-Schaltungstransistors (T1) gekoppelt und dazu ausgelegt ist, die erste Steuerspannung (VC1) zu empfangen, (ii) einen Source-Anschluss, der dazu ausgelegt ist, die Versorgungsspannung (VDDB) zu empfangen, und (iii) einen Drain-Anschluss, der mit dem Gate-Anschluss des ersten Pull-Up-Schaltungstransistors (T1) gekoppelt und dazu ausgelegt ist, die zweite Steuerspannung (VC2) zu erzeugen und an den Gate-Anschluss des ersten Pull-Up-Schaltungstransistors (T1) bereitzustellen;
eine Schutzschaltung (206), umfassend:
einen ersten Schutzschaltungstransistor (T5), der Folgendes aufweist: (i) einen Gate-Anschluss, der dazu ausgelegt ist, eine erste Referenzspannung (VR1) zu empfangen, und (ii) einen Source-Anschluss, der mit der Pull-Up-Schaltung (204) gekoppelt ist, und dazu ausgelegt ist, die Erzeugung der ersten Steuerspannung (VC1) zu steuern;
einen zweiten Schutzschaltungstransistor (T6), der Folgendes aufweist: (i) einen Gate-Anschluss, der dazu ausgelegt ist, die erste Referenzspannung (VR1) zu empfangen, und (ii) einen Source-Anschluss, der mit der Pull-Up-Schaltung (204) gekoppelt ist, und dazu ausgelegt ist, die Erzeugung der zweiten Steuerspannung (VC2) zu steuern;
einen dritten Schutzschaltungstransistor (T7), der Folgendes aufweist: (i) einen Gate-Anschluss, der dazu ausgelegt ist, die zweite Referenzspannung (VR2) zu empfangen, (ii) einen Source-Anschluss, der mit der Pull-Down-Schaltung (208) gekoppelt und dazu ausgelegt ist, die Erzeugung der ersten Vorspannung (VB1) zu steuern, und (iii) einen Drain-Anschluss, der mit einem Drain-Anschluss des ersten Schutzschaltungstransistors (T5) gekoppelt ist; und
einen vierten Schutzschaltungstransistor (T8), der Folgendes aufweist: (i) einen Gate-Anschluss, der dazu ausgelegt ist, die zweite Referenzspannung (VR2) zu empfangen, (ii) einen Source-Anschluss, der mit der Pull-Down-Schaltung (208) gekoppelt und dazu ausgelegt ist, die Erzeugung der zweiten Vorspannung (VB2) zu steuern, und (iii) einen Drain-Anschluss, der mit einem Drain-Anschluss des zweiten Schutzschaltungstransistors (T6) gekoppelt ist; und
einen Ausgangsgenerator (210), umfassend:
einen ersten Ausgangsgeneratortransistor (T9), der Folgendes aufweist: (i) einen Gate-Anschluss, der mit der Pull-Down-Schaltung (208) und der Schutzschaltung (206) gekoppelt und dazu ausgelegt ist, die zweite Vorspannung (VB2) zu empfangen, (ii) einen Source-Anschluss, der dazu ausgelegt ist, die zweite Referenzspannung (VR2) zu empfangen, und (iii) einen Drain-Anschluss, der dazu ausgelegt ist, eine erste Ausgangsspannung (VO1) zu erzeugen; und
einen zweiten Ausgangsgeneratortransistor (T10), der Folgendes aufweist: (i) einen Gate-Anschluss, der mit dem Drain-Anschluss des ersten Ausgangsgeneratortransistors (T9), der Pull-Down-Schaltung (208) und der Schutzschaltung (206) gekoppelt und dazu ausgelegt ist, die erste Vorspannung (VB1) zu empfangen, (ii) einen Source-Anschluss, der dazu ausgelegt ist, die zweite Referenzspannung (VR2) zu empfangen, und (iii) einen Drain-Anschluss, der mit dem Gate-Anschluss des ersten Ausgangsgeneratortransistors (T9) gekoppelt und dazu ausgelegt ist, eine zweite Ausgangsspannung (VO2) zu erzeugen; wobei
der Pegelschieber ferner umfasst:
ein Spannungsteilernetzwerk, das mit der Schutzschaltung (206) und dem Ausgangsgenerator (210) gekoppelt und dazu ausgelegt ist, die Versorgungsspannung (VDDB) zu empfangen, die erste und die zweite Referenzspannung (VR1, VR2) zu erzeugen und (i) die erste und die zweite Referenzspannung an die Schutzschaltung (206) und (ii) die zweite Referenzspannung (VR2) an den Ausgangsgenerator (210) bereitzustellen; **gekennzeichnet durch**
einen Widerstand (R4), der mit dem Spannungsteilernetzwerk (202) gekoppelt und dazu ausgelegt ist, die zweite Referenzspannung (VR2) zu empfangen; und
einen Kondensator (C1), der mit dem Widerstand (R4) und einem Masseanschluss gekoppelt und dazu ausgelegt ist, auf die zweite Referenzspannung (VR2) zu laden.

2. Pegelschieber (104) nach Anspruch 1, wobei das Spannungsteilernetzwerk (202) einen ersten, einen zweiten und einen dritten Widerstand (R1, R2, R3) umfasst, die in Reihe geschaltet sind, wobei der erste Widerstand (R1) dazu ausgelegt ist, die Versorgungsspannung zu empfangen, und der dritte Widerstand (R3) mit einem Masseanschluss gekoppelt ist und wobei die erste und zweite Referenzspannung (VR1, VR2) basierend auf einem Spannungsabfall über jeden von erstem (R1) bis drittem Widerstand (R3) erzeugt werden.

3. Pegelschieber (302) nach einem der vorhergehenden Ansprüche, wobei der Ausgangsgenerator (402) ferner mit der Pull-Up-Schaltung (204) gekoppelt und ferner dazu ausgelegt ist, die erste Referenzspannung (VR1) und die erste und die zweite Steuerspannung (VC1, VC2) zu empfangen und ferner eine dritte und eine vierte Ausgangsspannung (VO3, VO4) zu erzeugen, wobei die dritte und die vierte Ausgangsspannung (VO3, VO4) mit einem dritten Spannungsbereich assoziiert sind.

4. Pegelschieber nach Anspruch 3, wobei der Ausgangsgenerator ferner umfasst:
einen dritten Ausgangsgeneratortransistor (T11), der Folgendes aufweist: (i) einen Gate-Anschluss, der mit der Pull-Up-Schaltung (204) und der Schutzschaltung (206) gekoppelt und dazu ausgelegt ist, die zweite Steuerspannung (VC2) zu empfangen, (ii) einen Drain-Anschluss, der dazu ausgelegt ist, die erste Referenzspannung (VR1) zu empfangen, und (iii) einen Source-Anschluss, der dazu ausgelegt ist, die dritte Ausgangsspannung (VO3) auszugeben; und
einen vierten Ausgangsgeneratortransistor (T12), der Folgendes aufweist: (i) einen Gate-Anschluss, der mit dem Source-Anschluss des dritten Ausgangsgeneratortransistors (T11), der Pull-Up-Schaltung (204) und der Schutzschaltung (206) gekoppelt und dazu ausgelegt ist, die erste Steuerspannung (VC1) zu empfangen, (ii) einen Drain-Anschluss, der dazu ausgelegt ist, die erste Referenzspannung (VR1) zu empfangen, und (iii) einen Source-Anschluss, der mit dem Gate-Anschluss des dritten Ausgangsgeneratortransistors (T11) gekoppelt und dazu ausgelegt ist, die vierte Ausgangsspannung (VO4) auszugeben.

5. Pegelschieber (302) nach Anspruch 3 oder 4, wobei das Spannungsteilernetzwerk (202) ferner dazu ausgelegt ist, die erste Referenzspannung (VR1) an den Ausgangsgenerator (402) bereitzustellen.

6. Pegelschieber (302) nach Anspruch 5, ferner umfassend:
einen weiteren Widerstand (R5), der mit dem Spannungsteilernetzwerk (202) gekoppelt und dazu ausgelegt ist, die erste Referenzspannung (VR1) zu empfangen; und
einen weiteren Kondensator (C2), der mit dem weiteren Widerstand (R5) und dem Masseanschluss gekoppelt und dazu ausgelegt ist, auf die erste Referenzspannung (VR1) zu laden.

7. System-on-Chip, SoC, umfassend den Pegelschieber nach einem der vorhergehenden Ansprüche.

## Revendications

1. Dispositif de décalage de niveau (104), comprenant :
un circuit d'excursion basse (208) comprenant :
un premier transistor à circuit d'excursion basse (T3) qui comporte (i) une borne de grille configurée pour recevoir une première tension d'entrée (VI1), (ii) une borne de source couplée à une borne de masse et (iii) une borne de drain configurée pour générer une première tension de polarisation (VB1) ; et
un deuxième transistor à circuit d'excursion basse (T4) qui comporte (i) une borne de grille configurée pour recevoir une deuxième tension d'entrée (VI2), (ii) une borne de source couplée à la borne de masse et (iii) une borne de drain configurée pour générer une deuxième tension de polarisation (VB2) ;
un circuit d'excursion haute (204) comprenant :
un premier transistor à circuit d'excursion haute (T1) qui comporte (i) une borne de grille configurée pour recevoir une deuxième tension de commande (VC2), (ii) une borne de source configurée pour recevoir une tension d'alimentation (VDDB) et (iii) une borne de drain configurée pour générer une première tension de commande (VC1) ; et un deuxième transistor à circuit d'excursion haute (T2) qui comporte (i) une borne de grille couplée à la borne de drain du premier transistor à circuit d'excursion haute (T1) et configurée pour recevoir la première tension de commande (VC1), (ii) une borne de source configurée pour recevoir la tension d'alimentation (VDDB) et (iii) une borne de drain couplée à la borne de grille du premier transistor à circuit d'excursion haute (T1) et configurée pour générer et fournir la deuxième tension de commande (VC2) à la borne de grille du premier transistor à circuit d'excursion haute (T1) ;
un circuit de protection (206) comprenant :
un premier transistor à circuit de protection (T5) qui comporte (i) une borne de grille configurée pour recevoir une première tension de référence (VR1) et (ii) une borne de source couplée au circuit d'excursion haute (204) et configurée pour commander la génération de la première tension de commande (VC1) ;
un deuxième transistor à circuit de protection (T6) qui comporte (i) une borne de grille configurée pour recevoir la première tension de référence (VR1) et (ii) une borne de source couplée au circuit d'excursion haute (204) et configurée pour commander la génération de la deuxième tension de commande (VC2) ;
un troisième transistor à circuit de protection (T7) qui comporte (i) une borne de grille configurée pour recevoir la deuxième tension de référence (VR2), (ii) une borne de source couplée au circuit d'excursion basse (208) et configurée pour commander la génération de la première tension de polarisation (VB1) et (iii) une borne de drain couplée à une borne de drain du premier transistor à circuit de protection (T5) ; et
un quatrième transistor à circuit de protection (T8) qui comporte (i) une borne de grille configurée pour recevoir la deuxième tension de référence (VR2), (ii) une borne de source couplée au circuit d'excursion basse (208) et configurée pour commander la génération de la deuxième tension de polarisation (VB2) et (iii) une borne de drain couplée à une borne de drain du deuxième transistor à circuit de protection (T6) ; et
un générateur de sortie (210) comprenant :
un premier transistor générateur de sortie (T9) qui comporte (i) une borne de grille couplée au circuit d'excursion basse (208) et au circuit de protection (206) et configurée pour recevoir la deuxième tension de polarisation (VB2), (ii) une borne de source configurée pour recevoir la deuxième tension de référence (VR2) et (iii) une borne de drain configurée pour générer une première tension de sortie (VO1) ; et
un deuxième transistor générateur de sortie (T10) qui comporte (i) une borne de grille couplée à la borne de drain du premier transistor générateur de sortie (T9), au circuit d'excursion basse (208) et au circuit de protection (206), et configurée pour recevoir la première tension de polarisation (VB1), (ii) une borne de source configurée pour recevoir la deuxième tension de référence (VR2) et (iii) une borne de drain couplée à la borne de grille du premier transistor générateur de sortie (T9) et configurée pour générer une deuxième tension de sortie (VO2) ; dans lequel
le dispositif de décalage de niveau comprend en outre :
un réseau diviseur de tension couplé au circuit de protection (206) et au générateur de sortie (210), et configuré pour recevoir la tension d'alimentation (VDDB), générer les première et deuxième tensions de référence (VR1, VR2) et fournir (i) les première et deuxième tensions de référence au circuit de protection (206) et (ii) la deuxième tension de référence (VR2) au générateur de sortie (210) ; **caractérisé par**
une résistance (R4) couplée au réseau diviseur de tension (202) et configurée pour recevoir la deuxième tension de référence (VR2) ; et
un condensateur (C1) couplé à la résistance (R4) et à une borne de masse, et configuré pour se charger à la deuxième tension de référence (VR2).

2. Dispositif de décalage de niveau (104) selon la revendication 1, dans lequel le réseau diviseur de tension (202) comprend une première, une deuxième et une troisième résistance (R1, R2, R3) couplées en série, dans lequel la première résistance (R1) est configurée pour recevoir la tension d'alimentation et la troisième résistance (R3) est couplée à une borne de masse, et dans lequel les première et deuxième tensions de référence (VR1, VR2) sont générées sur la base d'une chute de tension à travers chacune des premières (R1) par l'intermédiaire des troisièmes résistances (R3).

3. Dispositif de décalage de niveau (302) selon l'une quelconque des revendications précédentes, dans lequel le générateur de sortie (402) est couplé en outre au circuit d'excursion haute (204) et configuré en outre pour recevoir la première tension de référence (VR1) et les première et deuxième tensions de commande (VC1, VC2), et pour générer en outre des troisième et quatrième tensions de sortie (VO3, VO4), dans lequel les troisième et quatrième tensions de sortie (VO3, VO4) sont associées à un troisième domaine de tension.

4. Dispositif de décalage de niveau selon la revendication 3, dans lequel le générateur de sortie comprend en outre :
un troisième transistor générateur de sortie (T11) qui comporte (i) une borne de grille couplée au circuit d'excursion haute (204) et au circuit de protection (206), et configuré pour recevoir la deuxième tension de commande (VC2), (ii) une borne de drain configurée pour recevoir la première tension de référence (VR1) et (iii) une borne de source configurée pour délivrer en sortie la troisième tension de sortie (VO3) ; et
un quatrième transistor générateur de sortie (T12) qui comporte (i) une borne de grille couplée à la borne de source du troisième transistor générateur de sortie (T11), au circuit d'excursion haute (204) et au circuit de protection (206), et configuré pour recevoir la première tension de commande (VC1), (ii) une borne de drain configurée pour recevoir la première tension de référence (VR1) et (iii) une borne de source couplée à la borne de grille du troisième transistor générateur de sortie (T11) et configurée pour délivrer en sortie la quatrième tension de sortie (VO4).

5. Dispositif de décalage de niveau (302) selon la revendication 3 ou 4, dans lequel le réseau diviseur de tension (202) est configuré en outre pour fournir la première tension de référence (VR1) au générateur de sortie (402).

6. Dispositif de décalage de niveau (302) selon la revendication 5, comprenant en outre :
une résistance (R5) supplémentaire couplée au réseau diviseur de tension (202) et configurée pour recevoir la première tension de référence (VR1) ; et
un condensateur (C2) supplémentaire couplé à la résistance (R5) supplémentaire et à la borne de masse et configuré pour charger la première tension de référence (VR1).

7. Système sur puce, SoC, comprenant le dispositif de décalage de niveau selon l'une quelconque des revendications précédentes.
